# EUROPEAN PATENT APPLICATION

(11) **EP 4 391 030 A1**
(43) Date of publication of application: **26.06.2024**
(21) Application number: 23214150.7
(22) Date of filing: 05.12.2023
(51) Int. Cl.: H01L 21/67, H01L 21/683

(54) **METHOD OF HEATING SEMICONDUCTOR STRUCTURE**

(30) Priority: 12.12.2022 EP 22212690
(71) Applicant: Comptek Solutions OY, 20520 Turku (FI)
(72) Inventor: Mäkelä, Jaakko, 20540 Turku (FI); Lång, Jouko, 21420 Lieto (FI); Alonso, Vicente, 20760 Piispanristi (FI)
(74) Representative: Moosedog Oy

(57) **Abstract**

Disclosed is a method (100) and a system (200) for heating a surface (202A) of a semiconductor structure (202) to be processed. The system (200) comprises an enclosure (204) and a fixture (214) adapted to mount the semiconductor structure (202) thereon. The system (200) further comprises a heating arrangement (208) comprising at least a laser heating source (210) configured for providing heat beam having a first beam profile (502) and an optical assembly (212), operatively coupled with the laser heating source, configured for modifying the first beam profile (502) of the heat beam from the laser heating source (208) to provide a modified heat beam having a second beam profile (504).

## Description

### TECHNICAL FIELD

The present disclosure relates to surface processing of semiconductor devices and more specifically to a method of heating a surface of a semiconductor structure to be processed.

### BACKGROUND

Surface processing of semiconductor materials or devices usually implies the need for heating up the semiconductor materials so that they reach certain temperature at which a particular process needs to be implemented. Such processing includes, among others, plasma cleaning, thin film depositions, coating, etc.

Conventionally, the existing heating solutions use radiating sources that impose a high thermal load on the semiconductor structure to be processed when the semiconductor structure is heated. Such heating solutions require the heating to be done from an opposite side, or from an opposite end, with respect to the surface of the semiconductor structure being processed. As a result, the heating sources become highly power consuming elements. The power consumption is due to the requirement to apply thermal energy to a surface opposing the surface to be processed. Such solutions leave the processed surface "free", or largely unaffected, requiring a higher thermal load to compensate for the indirect approach. Higher thermal loads imposed on the structures may lead to strain relaxation or internal substrate structural degradation, damaged surface layers, such as contacts, or other metallic layers present in the semiconductor chips, during processing, such as, during passivation processes that usually take place at later stages of the semiconductor manufacturing process, and when metallic layers are already present. A particular example of these problems is present during cleaning and passivation of laser surface facets of edge emitting lasers. Additionally, when it is sometimes required to passivate two opposing surfaces of laser chips, and to process (passivate or heat) both surfaces of the semiconductor structure, conventional processes require each surface to be processed independently and thereby making the system highly complex and time consuming.

There are other heating systems where some type of irradiation source is directed to the substrate, such as a laser beam spot, or laser beam line, that is scanned through the surface to be heated. In these solutions, the surface is not homogeneously heated up, and there are temperature gradients through the substrate surface. This is not acceptable for a wide variety of processing techniques, where it is required to have a very uniform temperature through the surface to be processed. Therefore, in light of the foregoing discussion, there exists a need to overcome the aforementioned drawbacks associated with existing treatment techniques and provide an improved method of heating a surface of a semiconductor structure to be processed.

### SUMMARY

The present disclosure seeks to provide a method of heating a surface of a semiconductor structure to be processed. An aim of the present disclosure is to provide a solution that overcomes at least partially the problems encountered in prior art.

In one aspect, an embodiment of the present disclosure provides a method of heating a surface of a semiconductor structure to be processed, the method comprising:
- providing an enclosure, comprising a fixture, to mount the semiconductor structure thereon;
- mounting the semiconductor structure on the fixture;
- providing, by a laser heating source, a heat beam having a first beam profile;
- modifying the first beam profile, by an optical assembly, to provide a modified heat beam having a second beam profile with a predefined intensity distribution, and a predefined size and shape, such that predefined size and shape correspond to a size and a shape of a first surface of the semiconductor structure to be processed, to cover substantially the entire surface area of the first surface of the semiconductor structure by the modified heat beam; and
- directing the modified heat beam having the second beam profile toward the first surface of the semiconductor structure for heating the first surface to be processed.

In another aspect, an embodiment of the present disclosure provides a system for heating a surface of a semiconductor structure to be processed, the system comprising:
- an enclosure;
- a fixture adapted to mount the semiconductor structure thereon;
- a heating arrangement (208) comprising at least:
   - a laser heating source, configured to provide heat beam having a first beam profile; and
   - an optical assembly, operatively coupled with the laser heating source,
wherein the optical assembly is configured to modify the first beam profile of the heat beam to provide a modified heat beam having a second beam profile and to direct the modified heat beam toward a first surface of the semiconductor structure for heating the first surface to be processed.

Embodiments of the present disclosure substantially eliminate or at least partially address the aforementioned problems in the prior art and provide an improved a method of heating a surface of a semiconductor structure ought to be processed.

### BRIEF DESCRIPTION OF THE DRAWINGS

Embodiments of the present disclosure will now be described, by way of example only, with reference to the following diagrams wherein:
FIG. 1 is a flowchart listing steps involved in a method of heating a surface of a semiconductor structure to be processed;
FIG. 2A (Prior Art) is a schematic diagram of a conventional system for heating a surface of a semiconductor structure;
FIG. 2B is a schematic diagram of a system for heating a surface of a semiconductor structure to be processed;
FIG. 2C is a schematic diagram of a heating system configured to heat the first surface and the second surface of the semiconductor structure simultaneously;
FIG. 2D is another embodiment of a system illustrated in FIG. 2B for heating a surface of a semiconductor structure to be processed;
FIG. 3A is a schematic diagram of an exemplary semiconductor structure stacking fixture for an enclosure of the system;
FIG. 3B is a detailed view of an exemplary fixture holding the plurality of semiconductor structures;
FIG. 4 is a representative diagram depicting heating operation of a surface of the semiconductor structure via the method or system;
FIGs. 5A and 5B are graphical representations of an exemplary first beam profile of the heat beam and the second beam profile of the modified heat beam, respectively;
FIGs. 6A and 6B, illustrated are exemplary heating arrangements configured for providing modified heat beam having different beam profiles;
FIGs. 7A to 7C, collectively, are graphical representations of different exemplary beam profiles of the modified heat beam; and
FIGs. 8A and 8B, illustrated are 2-D and 3-D intensity plots of the modified heat beam along with respective graphical intensity plots, respectively.

### DETAILED DESCRIPTION OF EMBODIMENTS

The present disclosure provides a method of heating a surface of a semiconductor structure ought to be processed.

The term *"heating"* as used herein refers to the process of application of thermal energy to the semiconductor structure or surface thereof, in order to enable treatment of the semiconductor device and thereby enable utilization in surface related semiconductor manufacturing processes such as, but not limited to, passivation, cleaning, exposure, development, coating, treatment, deposition, and the like. For example, the heating of the semiconductor structure is required to enable passivation of the semiconductor structure (or substrate) formed with surface oxidation processes, or with deposition of an oxide layer and/or a nitride layer onto the semiconductor structure such as, for utilization as a semiconductor laser device.

The term "*surface*" as used herein may also refer to a facet on the surface of the semiconductor structure.

Term *"semiconductor structure"* refers to a layer or block of a material upon or within which elements of a semiconductor device are fabricated or attached. In present examples, the semiconductor structure may be GaAs or Indium phosphide (InP), based structure which is suitable for forming the edge-emitting laser device, and other HEMT, MESFET, or other optoelectronic structures.

The method of the present disclosure is aimed to eliminate or at least partially reduce the limitations associated with high temperatures faced by conventional heating processes and/or systems, by providing a novel frontal heating mechanism. This is obtained by utilizing one or more selected (or preferred) laser devices that are configured to heat up only the targeted surface of the semiconductor structure while minimizing losses and defects associated therewith. Typically, in the method of the present disclosure, the entire surface of the semiconductor structure is heated via a laser beam that is adjusted using customized optical elements (either separately, or in combination) to configure the heat beam with a desired geometry, e.g., having a desired shape, a desired size and/or a desired intensity (intensity profile) to heat the surface of the semiconductor structure either uniformly, i.e., with same intensity over the entire surface area, or in a preferred manner.

Laser heating sources, such as, high-quality single-mode laser sources, generally emit heat beams following a low-order Gaussian irradiance profile. However, such heat beams having the Gaussian beam profile have low-intensity portions on either side of the usable central region (also known as "wings"), which is typically wasted since the wings possess a lower intensity than an intensity (or ablation) threshold required for an effective heating operation and therefore there is a need to modify the beam profile in certain way to improve the accuracy of the heating.

For example, the heat beam from the laser source may be configured to obtain higher intensity on the edges of a surface of the semiconductor structure and lower intensity at the centre of the surface of the semiconductor structure. The heat beam may also be configured to compensate for the higher heat exchange rates at certain surface areas of the semiconductor structure, for example, at the edges of the semiconductor structure. Moreover, the heat beam is configured to be modified based on the characteristics of the semiconductor structure (such as, shape of the surface of the semiconductor structure and absorption characteristics thereof) in a manner to accommodate the entire surface area of the semiconductor structure, to avoid unnecessary heating of the adjacent fixture, or the surrounding enclosure, and to minimize and/or eliminate potential surface deterioration and/or defects.

Herein, the method is configured to enable selection of power or wavelength(s) of the heating laser(s) such that the heat radiation is efficiently absorbed by the surface of the structure being heated and thereby quickly dissipated. The method is configured to provide localized heating of the semiconductor structure to effectively treat only the exposed surfaces and prevent unwanted damages thereof. Moreover, beneficially, the method of the present disclosure provides for simultaneous heating and/or processing of both surfaces of the semiconductor structure, wherein the heating process comprises rapid heating and cooling periods, further increasing the processing speed, and thereby improving the manufacturing output and operational efficiency while minimizing the associated operational costs and time. Additionally, beneficially, the method of the present disclosure enables heating and/or processing of the two opposed surfaces of a semiconductor structure at the same time. For example, in cleaved semiconductor structures, such as laser bars, both facets may need to be processed. The method enables both facets of the semiconductor structure to be processed at the same time and within a single chamber in an efficient manner. There can be two different heating laser systems within a single enclosure: one heating source for each surface, and corresponding two cleaning sources, are present for processing of each surface of the cleaved semiconductor structure. Correspondingly, other semiconductor manufacturing processes, such as, the passivation process, deposition process, are enabled to be performed on both surfaces of the semiconductor structure simultaneously.

The method of the present disclosure comprises providing an enclosure comprising a fixture to mount the semiconductor structure thereon. The *"enclosure"* refers to an external body (or structure) that may comprise a single-chamber system for inertly storing a given semiconductor structure and preventing exposure from the surroundings during treatment or operation. For example, the enclosure is a vacuum chamber configured to provide ultra-high-vacuum level between 10⁻⁷ millibar (mbar) and 10⁻¹² mbar, high-vacuum level between 10⁻⁷ mbar and 10⁻³ mbar, medium vacuum level between 10⁻³ mbar and 1 mbar, and/or a vacuum ranging between atmospheric pressure and 1 mbar. Optionally, the enclosure may comprise a chamber, wherein the given semiconductor structure may be loaded or transferred.

Further, the enclosure comprises the fixture configured to mount the given structure (upon being loaded) to the enclosure. The term *"fixture"* refers to a customized support device configured to securely locate, support, and mount the semiconductor structure while leaving the surfaces to be processed freely exposed and enable external manipulation thereof. In an example, the fixture may be a type of jig (such as, a stacking jig, a plate jig, channel jigs, etc.). In another example, the fixture may be a metallic frame configured to mount multiple cleaved semiconductor structures. In the case of processing semiconductor cleaved structures, such as laser bars, multiple such semiconductor bars may preferably be stacked in the fixture for simultaneous processing, allowing for bulk production and high throughput. Optionally, the cleaved semiconductor structures are mounted on the fixture (such as, a stacking jig), such that the surface(s) (or facets) of the multiple cleaved semiconductor structures are aligned in the same direction, and the treatment steps of the method affect each of the facets in a similar manner. Although the semiconductor structure referred to herein, and in connection with the present disclosure, may be cleaved, the semiconductor structures referred to herein are not limited to cleaved semiconductor structures.

The method of the present disclosure further comprises providing a heating arrangement. The term *"heating arrangement"* as used herein refers to an arrangement comprising multiple mechanical, software, or firmware components configured for generation of heat beam(s) to treat the surface of the semiconductor ought to be processed. Alternatively stated, the heating arrangement may be configured for heat transfer to the surface of the semiconductor structure or maintaining a desired temperature thereat. Conventionally, the heating of semiconductor structures is done from a back side i.e., in a direction, different from the other semiconductor manufacturing components such as, oxidation sources, deposition sources, cleaning sources, and the like. Notably, such conventional heating mechanisms or arrangements, that are operable to heat the semiconductor structure from the back side, increase the amount of required heat energy and corresponding time taken for heating the surface of the semiconductor structure. Moreover, such higher amounts of heat energy required for heating the semiconductor structure also results in surface deterioration and other imperfections reducing the efficacy of the semiconductor being manufactured. Notably, to overcome the aforementioned drawbacks, the method of the present disclosure provides a frontal heating arrangement i.e., the heating arrangement is arranged facing the surface of the semiconductor surface to be processed. Alternatively stated, the heating arrangement is arranged on the same side and in conjunction with other semiconductor manufacturing components as aforementioned. Beneficially, the frontal heating arrangement enables reduction of heat consumption and corresponding time taken to improve the efficiency of the heating arrangement while eliminating or at least minimizing surface deterioration and associated defects.

In an embodiment, providing the heating arrangement comprises selecting a laser heating source based on material properties, including, one or more absorption characteristics, or a thermal profile, of the material of the semiconductor structure. Typically, the laser heating source is selected based on the material properties of the semiconductor structure to beneficially provide the heat beam having preferred laser beam characteristics to effectively and efficiently heat the surface of the semiconductor structure. Thus, based on the material properties of the semiconductor structure such as, absorption characteristics (such as, absorption coefficient, absorption wavelengths, dopant density, etc.), thermal properties (such as, thermal diffusivity, temperature dependence of band gap, thermal conductivity, etc.), electrical properties such as (refraction index, breakdown field, etc.), band structure properties (such as, dielectric constant, intrinsic resistivity, energy gap, etc.), crystal properties (such as, critical temperature, density, lattice spacing, critical pressure, etc.), size and shape of the semiconductor structure, the laser heating source may be selected to heat the surface of the semiconductor structure in an efficient manner to enable precise materials processing with high accuracy and minimal damage to surrounding areas.

In one or more embodiments, the laser heating source is mounted externally to the enclosure. There is further provided a transparent viewport to allow the heat beam from the laser heating source to reach the semiconductor structure. The term *"viewport"* refers to an access port configured to allow the heat beam from the heating source to reach the exposed first surface of the semiconductor structure, i.e., after, or during, any manufacturing process such as cleaning, coating, and/or oxidation process of the surface etc. It will be appreciated that based on the needs of the implementation, the location of the laser heating source may be varied. The laser heating source may be mounted externally near to the enclosure and coupled to via an optical fibre ranged through the viewport, for example, to reduce the physical footprint of the implementation.

In an embodiment, a heat power density used in the laser heating source is in a range of 0.2-20 W/cm2. In the method of the present disclosure, the heat power intensities used for laser heating may be typically in the range of 0.2-200 W/cm2. For example, in the range of 1-100 W/cm2, wherein a higher power density means a higher temperature. The shorter and higher intensity of the pulse, the more it will have heating effect localized to the surface. In an embodiment, a pulse width used in the laser heating source is in the range of 10-100µs, and a period width used in the laser heating source is in a range of 100-400µs. In excimer lasers, a pulse width in the range of ~ns may be used to decompose the surface oxides. To achieve a sufficient heating effect, the width of the pulse used can be, for example, in the range 10-100 ms, for rise/fall times ~20 ms, and the width of the period can be, for example, in the range 100-400 ms. The highest power and shortest pulse width are expected to give the best result.

The heating arrangement comprises a laser heating source configured for providing a heat beam having a first beam profile. The laser heating source is configured to emit the heat beam having the first beam profile to enable heat treatment of the semiconductor structure (or surface thereof). For example, the heat beam may be at least one of: an UV beam, an infrared beam, a continuous wave (CW) beam, a pulsed beam. In an example, the method may employ micro pulse lasers or high-power lasers, i.e., short pulse laser having high power for heating the surface of the semiconductor structure without damaging the surface thereof. Herein, since the power input (or peak power) to the high-power short pulse laser is extremely high for a shorter duration, the heat-affected zone (HAZ) is lower than other types of lasers and the heating process takes lesser time in comparison to other types of lasers.

In an embodiment, the method may further comprise selecting laser beam characteristics to improve the cooling down or heat dissipation through the substrate to prevent the heat up mechanism that will otherwise damage the semiconductor structure. In still other examples, the method may employ continuous wavelength lasers, or pulse lasers of different wavelengths or powers based on the implementation. It will be appreciated that the method may vary the essential laser parameters such as laser intensity, wavelength, pulse duration, pulse width, and incident angle to potentially improve the heating effect on the surface and at the same time promote the efficient heat dissipation through the sample and may employ any laser heating source and corresponding heat beam techniques based on the needs of the implementation. The method may be configured to provide the heat beam with the selective wavelength(s), where the wavelength of the heat beam from the heating source is suitably varied to effectively heat only the exposed first surface of the semiconductor structure and preventing any potential damage thereof. By employing such heating technique, beneficially other components are not heated, and the enclosure is therefore operating at low temperatures.

Further, the heat beam from the laser heating source may be configured to eliminate contaminants from the semiconductor structure (or surface thereof) efficiently and accurately owing to the higher precision control and increased energy efficiency of the heat beam provided by the laser heating source.

Beneficially, the laser radiation provides high accuracy and precision control of the heat beam output and results in minimal or distortion and/or stress to the heated surface during operation.

The term *"beam profile" as* used herein refers to a spatial intensity profile, along a given plane transverse to the propagation path, of the heat beam. For example, the beam profile may a Gaussian beam profile, a flat-top beam profile, and the like. The geometry of the beam may be any shape and size, for example, ring shape, circular, rectangular, triangular, or polygonal. Herein, in the method, the first beam profile of the heat beam from the laser heating source may be a Gaussian beam profile, or a quasi-Gaussian profile. The Gaussian beam profiles are symmetric around the center of the beam and their intensity decreases as the distance from the center of the beam perpendicular to the direction of propagation increases. Further, due to diffraction, the Gaussian heat beam may converge and/or diverge from an area called the beam waist, which is where the beam diameter reaches a minimum value. The beam converges and diverges equally on both sides of the beam waist by a divergence angle (or scatter angle). Thus, the heat beam having the Gaussian beam profile provides a non-uniform temperature distribution and therefore results in uneven heating of the semiconductor structure which potentially results in surface deterioration and a poorer quality semiconductor device.

Thus, to overcome the aforementioned drawbacks, the heating arrangement further comprises an optical assembly, operatively coupled with the laser heating source, configured for modifying the first beam profile of the heat beam from the laser heating source to provide a modified heat beam having a second beam profile. The optical assembly is located inside the enclosure and operatively coupled with the laser heating source located outside the enclosure via any conventional coupling means such as, an optical fibre. Optionally, the optical assembly is either detachably coupled with the laser heating source, or mechanically coupled therewith. Herein, in the method, the heat beam from the laser heating source is directed towards (or passed through) the optical assembly to modify the heat beam into the modified heat beam having the second beam profile. The term *"optical assembly"* as used herein refers to an arrangement of optical devices configured to, either independently, or in combination with one another, define or alter the distribution or phase of the irradiated heat beam from the laser heating source. The optical assembly may be operable to redistribute the irradiance and phase of the heat beam to attain a desired beam profile that is maintained along the desired propagation distance. For example, the optical assembly may comprise an array of optical lenses configured to adjust the first beam profile of the heat beam based on the size or shape of the semiconductor surface i.e., the first beam profile may be expanded or focused based on requirement to provide the second beam profile of the modified heat beam. Alternatively stated, the optical assembly refers to an arrangement of optical devices configured to modify the characteristics (such as, shape, aperture, intensity, etc.) of the heat beam from the laser heating source to provide the modified heat beam having the second beam profile. In some examples, in the method, the laser heating source may provide a heat beam having a Gaussian distribution (wherein irradiance decreases with increasing radial distance) to the optical assembly to modify the Gaussian distribution (first beam profile) of the heat beam into a flat top distribution (wherein irradiance is constant over a given area) to provide a modified heat beam to be utilized for accurately and efficiently heating the surface of the semiconductor structure. In other examples, Gaussian beams may be physically truncated by an aperture to form a pseudo-flat top profile to reduce the associated operational costs. Beneficially, since the heat beams with flat top profiles (i.e., the second beam profile) are more efficient in comparison to Gaussian distributions (i.e., the first beam profile) because of larger beam area with superfluous energy higher than the required intensity threshold and energy lower than the intensity threshold in the outer regions (or wings) of the Gaussian distribution. Notably, the second beam profile of the modified heat beam may be either uniform, or non-uniform, i.e., the intensity distribution of the heat beam may be varied based on the needs of the implementation without any limitations to the present disclosure.

In an embodiment, modifying the first beam profile of the heat beam from the laser heating source into the second beam profile via the optical assembly comprises defining at least one of: a power intensity, a power distribution, a size, a shape, a polarization, a phase, of each heat beam, by utilizing at least one optical device to provide the modified heat beam having the second beam profile. Typically, the optical assembly is configured to modify the first beam profile by defining (or altering) one or more characteristics of the heat beam from the laser heating source to provide the second beam profile, wherein the second beam profile is generated by modification or alteration of at least one of the power intensity or distribution, the shape, the size, the polarization, the phase, of the heat beam, via at least one optical device of the optical assembly.

The optical assembly of the present disclosure provides an assortment of modifications for the heat beam and enables the method to provide different modified heat beams based on the needs of the implementation. It will be appreciated by a person skilled in the art that the number and arrangement of the at least one optical device in the optical assembly is dependent on various factors, such as, size or shape of the semiconductor structure, the required intensity profile of the modified heat beam, and the like, and thus, may be varied interchangeably without any limitations.

During heating the semiconductor structure(s), the heating area can be made very small, that is heating only the exposed surface of the semiconductor structure. For example, the heat beam may be shaped according to the geometry of the exposed surface of the semiconductor structure so that only the semiconductor structure is heated up. In present examples, the heat (laser) beam may be made rectangular, or circular, or may be made variable using beam shapers, so that the heating area is defined and localized. Optionally, refractive beam shapers convert input Gaussian beam profiles to collimated Airy disk profiles. In another example, the at least one optical device is a beam homogenizer (or integrator), wherein the beam homogenizer may be at least one of a diffractive beam homogenizer, or an imaging beam homogenizer, or a waveguide. Homogenizers may be configured to transform a collimated round input beam (i.e., the heat beam with the first beam profile) into a rectangular output beam with a top-hat intensity distribution (i.e., the modified heat beam having the second beam profile). For example, the square shape of the output beam may be made by combining multiple microlens arrays, that also homogenize the power intensity. The size of the second beam profile can be varied from i.e., (1-5) mm x (1-5) mm to (10-50) mm x (10-50) mm. In an example, the second beam profile may be circular with a diameter of 5 mm to 100 mm. In another example, the second beam profile size may be varied from 1 mm x 1 mm to 10.0 mm x 16.0 mm. In another example, the second beam profile size may be varied 5 mm x 8 mm to 30 mm x 40 mm. Typically, the beam homogenizer comprises one or more array of optical lenses (or lenslets) operable to divide the incident heat beam from the laser heating source into multiple smaller heat beams (or beamlets). For example, the array(s) of optical lenses may be a polymethyl methacrylate (PMMA) micro-lens array. The beam homogenizer further comprises a focusing lens configured to superimpose the beamlets into the modified heat beam directed at the target plane i.e., the surface of the semiconductor structure, wherein the second beam profile of the modified heat beam is typically the sum of the diffraction patterns determined by each lenslet in the array of optical lenses. Optionally, Alternatively, to reduce surface reflections, the homogenizers are also coated with broadband antireflection (BBAR) coatings that provide lesser than 0.8% average reflectance per optic surface from 420 nanometres (nm) to 700 nm, or from 650 nm to 1050 nm. Moreover, optionally, other optomechanical and/or optical components, such as lens tubes, additional lenses, and filters, can be installed along the optical axis of each homogenizer without any limitations to the present disclosure.

The shape and size, and the intensity, of the modified heat beam may be pre-defined based on the size and shape of the surface of the semiconductor structure to be heated. In one or more embodiments, the predefinition is done in such a way that the shape and size of the modified heat beam correspond to the shape and size of the semiconductor surface, to substantially cover the entire surface area of the semiconductor structure to be heated. For example, the shape and size of the modified heat beam can be the same as the shape and size of the heated surface, or slightly larger, or slightly smaller than the surface area of the surface of the semiconductor structure. The shape and size of the modified heat beam can also be predefined in such a way that the modified heat beam only covers certain portions of the surface of the semiconductor structure to be heated. In addition, it may be possible to modify the heat beam in such a way that different portions (or different areas) of the surface area of the surface the semiconductor structure can be exposed to different intensities, or intensity distributions, of the heat beam during heating.

In an embodiment, the method further comprises determining at least a size and a shape of the first surface of the semiconductor structure and modifying the first beam profile of the heat beam from the laser heating source, via the optical assembly, into the second beam profile based on the determined size and shape of the first surface of the semiconductor structure. Typically, to improve the accuracy of the heating operation, the method is further configured to determine the size and shape of the first surface of the semiconductor structure such that the first beam profile of the heat beam from the laser heating source may be modified based on the determined shape and size of the first surface of the semiconductor structure. In an example, wherein the first surface of the semiconductor structure comprises a rectangular shape with a length of 15 millimeters (mm) and a breadth of 15 mm, the method is configured to modify the first beam profile into the second beam profile such that the shape of the modified heat beam i.e., the second beam profile, corresponds to the shape and size of the first surface of the semiconductor structure. Beneficially, such a determination of the size and shape of the first surface of the semiconductor structure enables the method to effectively heat only the first surface and not the surrounding areas (i.e., the fixture or enclosure) to accurately heat the semiconductor structure while minimizing the associated heat losses. The determination of the size and shape may be done manually (such as, via calipers, or gauges), or via machine learning algorithms such as, object detection, contouring, fitting, measurement, and other similar image processing techniques, to automate the entire heat treatment process via the method.

In an embodiment, the method further comprises providing a second heating arrangement comprising a second laser heating source configured for providing heat beam having a third beam profile, and a second optical assembly, operatively coupled with the second laser heating source, configured for modifying the third beam profile of the heat beam from the second laser heating source into a modified heat beam having a fourth beam profile and directing the modified heat beam towards a second surface of the semiconductor structure, for heating the second surface to be processed. It will be appreciated that the second heating arrangement may be similar to the aforementioned heating arrangement, and the third beam profile of the heat beam from the second laser heating source may be similar or different from the first beam profile of the heat beam from the laser heating source. Similarly, the fourth beam profile of the modified heat beam from the second laser heating source may be similar or different from the second beam profile of the modified heat beam from the laser heating source.

The second heating arrangement is configured for heat treatment of the second surface of the semiconductor structure and is arranged in a direction opposite to the heating arrangement i.e., towards the second surface of the semiconductor structure to directly heat the second surface while requiring a lower heat load in comparison to conventional solutions that require heating to be done from an opposite end (or side). Beneficially, as the heating can happen from the same side where the processing of the semiconductor takes place, such an implementation of the heating arrangement in conjunction with the second heating arrangement positioned in a opposite direction enables treatment of both surfaces i.e., the first surface and the second surface, simultaneously, which is an important consideration in semiconductor manufacturing processes such as, passivation process. Moreover, such an implementation enables the method to employ other surface treatment techniques along with the heat treatment process of the present method and thereby reduces the time taken and thermal load required for heating (or processing) the semiconductor structure.

In cases where there is only one heating source, the fixture may be rotated, by a manipulator, in the enclosure to expose the second surface of the semiconductor structure to the modified heat beam from the laser heating source, without removing the semiconductor structure from the enclosure. It is preferable, in some semiconductor manufacturing processes, to form the passivation layer on both opposing surfaces of the semiconductor structure i.e., the first facet and the second facet, to prevent contaminants and amorphous oxide layer formation thereat. Herein, to form the passivation layer on the second facet, the orientation of the semiconductor structure within the enclosure is modified by manipulating the fixture such that the second facet may be exposed to one or more of the cleaning beams from the cleaning source, the heat beam from the laser heating source and the oxidation agent from the oxidizing source in. In contrast to conventional techniques, the reconfiguration of the fixture allows the second facet to be exposed to the said process(es) without the need to remove the semiconductor structure from the enclosure. The manipulating the fixture comprises reorienting or repositioning the fixture, comprising the mounted semiconductor structures, from a first orientation to a second different orientation within the enclosure such that the second facet are exposed to further treatment.

In an embodiment, the method further comprises determining power of the heat beam, or the modified heat beam, via a laser power meter and determining a temperature distribution of the first surface, or the second surface, of the semiconductor structure via a thermal sensor. Typically, to automatically enable self-correction based on obtained feedback, the method of the present disclosure is further configured to determine the power (or intensity) of the modified heat beam via the laser power meter such that the second beam profile may be varied based on the requirement upon assessing the current power of the modified heat beam. Such an implementation ensures that the laser heating source provides the same power, the system further comprises the laser power meter to measure the power of the heat beam, or the modified heat beam, and can be used to modify the current administrated to the laser such that the power level remains constant. Additionally, the method is further configured to determine the temperature distribution of the first surface, or the second surface, of the semiconductor structure via the thermal sensor either before, during, or after the heating operation such that the surface temperature may be varied based on implementational requirement upon assessing the current temperature distribution of the surface(s) of the semiconductor structure. The thermal sensor may be a pyrometer, or infrared thermometer, a thermal imaging sensor, and the like, configured to determine the temperature distribution at the surface of the semiconductor structure based on the amount of thermal radiation being emitted from the surface of the semiconductor structure.

In another embodiment, the method further comprises altering the second beam profile, or the fourth beam profile, of the modified heat beam based on at least one of: the power determined via the laser power meter, the temperature distribution determined via the thermal sensor. Typically, to enable a corrective feedback loop, the method further comprises altering the second beam profile i.e., the power intensity, size, and shape, of the modified heat beam based on the determined power of the modified heat beam and the temperature distribution along the surface (i.e., the first surface or the second surface) of the semiconductor structure.

The present disclosure also provides a system for heating a surface of a semiconductor structure to be processed. The various embodiments and variants disclosed above apply mutatis mutandis to the present system without any limitations.

The system comprises an enclosure which may be a sealed chamber for processing the semiconductor structure. To develop appropriate environment necessary for processing of the semiconductor structure, the system may further comprise a pump configured to generate vacuum condition inside the enclosure. The *"pump"* as used herein refers to a vacuum pump configured to draw gas molecules from an enclosed space (such as, the enclosure) to create a partial vacuum i.e., to generate vacuum conditions inside the said enclosure. It will be appreciated that the pump comprises inherent piping system (i.e., network of connected pipes or tubes) interconnected with the enclosure to generate the vacuum conditions and wherein the pump utilized for generating the vacuum conditions may be selected based on the implementation to optimize the method without limiting the scope of the present disclosure. For example, the pump may be selected from at least one of, but not limited to, positive displacement pumps, regenerative pumps, entrapment pumps.

The system further comprises a heating arrangement comprising at least a laser heating source configured for providing heat beam having a first beam profile. The heating arrangement comprises the laser heating source mounted in the enclosure. The laser beam from the laser heating source may be arranged in the enclosure via an optical fibre feedthrough. In particular, the system comprises a viewport for mounting the laser heating source in the enclosure. The term "*viewport*" refers to an aperture or opening that extends through a wall of the enclosure, wherein the shape, size and curvature of the ports may be varied as per the requirements of the implementation. In an example, the port may be cylindrical port. It will be appreciated that the shape and size of the ports may be varied without limiting from the scope of the teachings herein. In one or more embodiments, the selection of the laser heating source is done based on the material of the semiconductor structure and the conditions thereat to perform the heating step effectively and efficiently. In the present embodiments, the laser heating source is configured to provide the directed heat beam by laser irradiation. The heating arrangement further comprise an optical assembly, operatively coupled with the laser heating source, configured for modifying the first beam profile of the heat beam from the laser heating source to provide a modified heat beam having a second beam profile. The optical assembly comprises at least one optical device configured to define or alter the distribution or phase of the heat beam to alter the first beam profile into the second beam profile to provide the modified heat beam to be utilized for accurately and efficiently heating the surface(s) of the semiconductor structure. In one or more embodiments, the at least one optical device of the optical assembly is selected from at least one of: a collimator lens, a beam shaper, a beam homogenizer, an optical lens, a light guide, an optical filter.

The system further comprises a fixture adapted to mount the semiconductor structure thereon in the enclosure, wherein the fixture is configured to expose a first surface of the semiconductor structure to the modified heat beam having the second beam profile for treatment thereof. Herein, the fixture is configured to expose the first surface of the semiconductor structure to the modified heat beam having the second beam profile, by disposing the first surface opposing the laser heating source.

In one or more embodiments, the system further comprises a second heating arrangement comprising a second laser heating source configured to provide heat beam having a third beam profile, and a second optical assembly, operatively coupled with the second laser heating source, configured for modifying the third beam profile of the heat beam from the laser heating source into a modified heat beam having a fourth beam profile for treatment thereof.

Optionally, the system further comprises a gate valve to control the conditions inside the enclosure and a controller configured to manipulate the fixture and control the movement and/or position of the fixture, by transmitting command signals to the fixture, for providing different positional configurations of the semiconductor structure for treatment within the enclosure. The "gate valve" refers to a type of valve (also known as a sluice valve), that opens by lifting a barrier out of a path. Beneficially, gate valves require very little space along transfer axis and hardly restrict the transfer when the gate is fully opened and thereby minimizes the physical footprint of the system. The term "controller" as used herein refers to a structure and/or module that includes programmable and/or non-programmable components configured to store, process and/or share information and/or signals for controlling the pump, gate valve, and/or the fixture. The controller may be operatively coupled to the gate valve, and/or the fixture. Herein, the gate valve is configured to maintain conditions inside the enclosure, unless the controller transmits a command signal to open the gate valve for transfer of the semiconductor structure from the enclosure. In the present examples, the controller may include components such as memory, a controller, a network adapter, and the like, to store, process and/or share information with other components, such as a sensor, a remote server unit, a database, etc. Additionally, the system elements may communicate with each other using a communication interface.

### DETAILED DESCRIPTION OF THE DRAWINGS

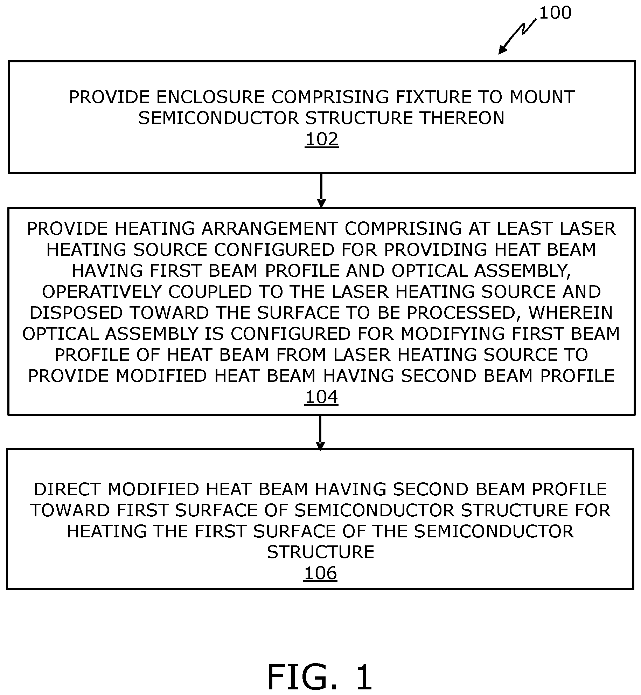

Referring to FIG. 1, illustrated is a flowchart listing steps involved in a method **100** of heating a semiconductor structure surface for utilization in semiconductor manufacturing processes, in accordance with an embodiment of the present disclosure. At a step **102,** the method **100** comprises providing an enclosure having a fixture to mount the given semiconductor structure thereon, in the enclosure. Herein, the enclosure is adapted to provide vacuum condition inside thereof. The vacuum conditions are provided (such as, via a pump) inside the enclosure to prevent external exposure to surroundings during processing and/or treatment of the semiconductor structure and prevent damage thereof (such as, due to catastrophic optical mirror damage (COMD), corrosion). At a step **104,** the method **100** further comprises providing a heating arrangement comprising at least a laser heating source configured for providing a heat beam having a first beam profile and an optical assembly, wherein the optical assembly is operatively coupled with the laser heating source, and disposed facing toward a first surface to be processed, configured for modifying the first beam profile of the heat beam from the laser heating source to provide a modified heat beam having a second beam profile. And, at a step **106,** the method **100** further comprises directing the modified heat beam having the second beam profile toward the first surface of the semiconductor structure for treatment thereof. Optionally, to enable heat treatment of both surfaces of the semiconductor structure simultaneously, the method **100** further comprises step of providing a second heating arrangement, comprising a second laser heating source, configured for providing heat beam having a third beam profile, and a second optical assembly, operatively coupled with the second laser heating source, wherein the second optical assembly is configured for modifying the third beam profile of the heat beam from the second laser heating source into a modified heat beam having a fourth beam profile, and directing the modified heat beam toward a second surface of the semiconductor structure.

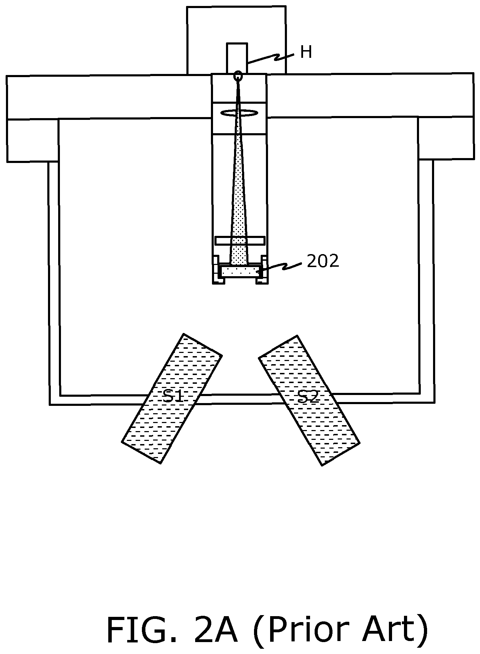

Referring to FIG. 2A (Prior art), illustrated is a schematic diagram of a conventional system for heating a surface of a semiconductor structure. As shown, the heating source **H** is configured to emit the heat beam from a direction opposite to the surface of the semiconductor structure being treated via external sources **S1** and **S2.** Such an implementation increases the amount of thermal energy required for heating the semiconductor structure and increases the time required for the said operation. Further, owing to the higher amounts of heat energy, the semiconductor structure is susceptible to surface defects and/or damages during operation. Herein, the heating source **H** provides the heat beam only to a part of the surface and not the entire surface of the semiconductor structure **202** and thereby results in uneven heating thereof. Furthermore, the heat beam from the heating source **H** is non-uniform and therefore heats up the surface of the semiconductor structure **202** in a non-uniform manner which potentially results in surface defects or deterioration. Thus, a requirement for a novel method or system for heating the entire surface(s) of the semiconductor structure **202** in a desired manner accurately and efficiently is developed.

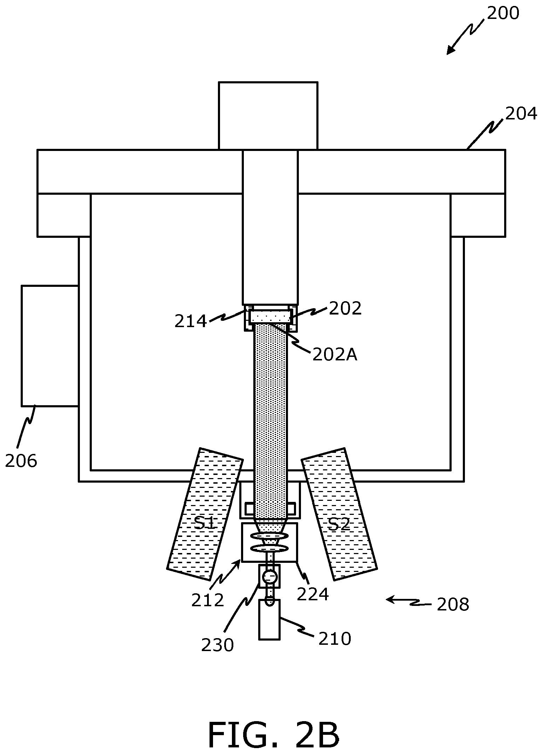

Referring to FIG. 2B, illustrated is a schematic diagram of a system **200** for heating a surface **202A** of a semiconductor structure **202** to be processed, in accordance with one or more embodiments of the present disclosure. As shown, the system **200** comprises an enclosure **204,** a pump **206** configured to generate vacuum condition inside the enclosure **204.** The enclosure **204** is shown as a quadrilateral structure, however, the enclosure **204** may be shaped or designed differently, for example, the enclosure **204** may have a cylindrical or spherical structure. The system **200** further comprises a heating arrangement **208** comprising at least a laser heating source **210** configured for providing heat beam having a first beam profile and an optical assembly **212,** operatively coupled with the laser heating source **210,** configured for modifying the first beam profile of the heat beam from the laser heating source **210** to provide a modified heat beam having a second beam profile. Notably, the heating arrangement **208** is frontal heating arrangement i.e., the heating operation is implemented from the same side as that of other semiconductor manufacturing sources **S1** and **S2.** The system **200** further comprises a fixture **214** adapted to mount the semiconductor structure **202** thereon in the enclosure **204,** wherein the fixture **214** is configured to expose a first surface **202A** of the semiconductor structure **202** to the modified heat beam having the second beam profile for treatment thereof. Herein, the heat beam is emitted from the laser heating source **210** and thereby directed toward the optical assembly **212,** by an optical means **230,** for further modification of the heat beam. Specifically, as shown, the heat beam having the first beam profile is expanded via the optical assembly **212** such that the modified heat beam completely and accurately envelops the entire first surface **202A** of the semiconductor structure **202** to enable effective heat treatment thereof without heating the surrounding fixture **214.** Optionally, the first beam profile of the heat beam is passed through at least one optical device **224** configured to modify the first beam profile of the heat beam into the second beam profile to provide the modified heat beam.

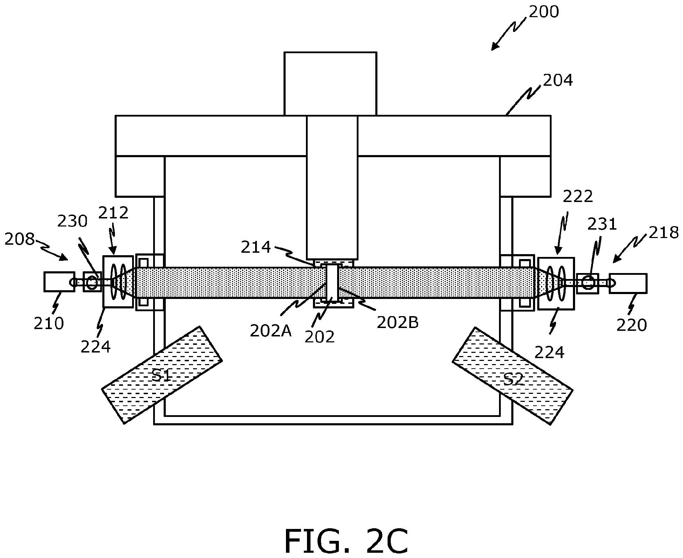

Referring to FIG. 2C, illustrated is a schematic diagram of a dual heating system **200** configured to heat the first surface **202A** and the second surface **202B** of the semiconductor structure simultaneously, in accordance with one or more embodiments of the present disclosure. It will be appreciated that FIG. 2C is read in conjunction with FIG. 2A and 2B. As shown, the system **200** further comprises a second heating arrangement **218** comprising a second laser heating source **220** configured to provide heat beam having a third beam profile and a second optical assembly **222,** operatively coupled, by an optical means **231,** with the second laser heating source **220,** configured for modifying the third beam profile of the heat beam from the laser heating source **220** into a modified heat beam having a fourth beam profile for treatment thereof. Herein, the fixture **214** may be, optionally, manipulated, e.g., to be rotated by e.g., a 90-degree or 180-degree angle, such that both the first surface **202A** and the second surface **202B** of the semiconductor structure **202** can be heated with one heating arrangement. With two heating arrangements **208** and **218,** both surfaces **202A,** and **202B** can be heated simultaneously, from opposite directions, without manipulation of the fixture. Beneficially, such an implementation of the system **200** enables treatment (or passivation) of both surfaces **202A** and **202B** of the semiconductor structure simultaneously in a precise and efficient manner.

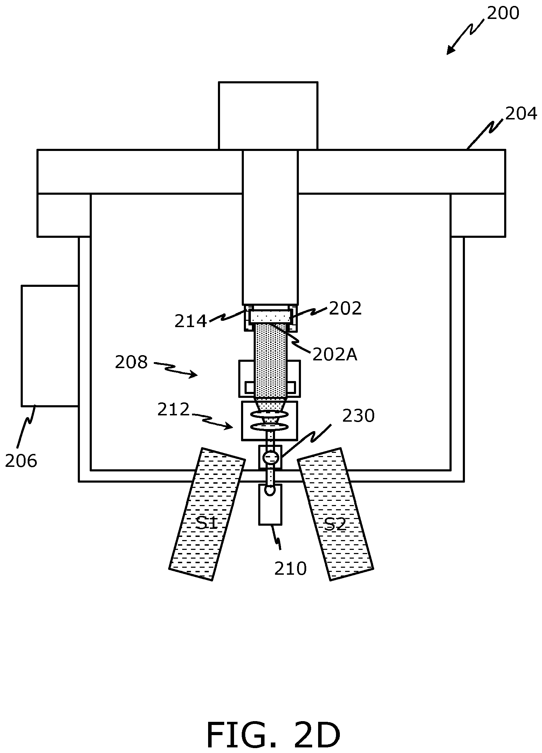

Referring to FIG. 2D, illustrated is another embodiment of a system illustrated in FIG. 2B. If compared to FIG. 2B, it can be noted that in FIG. 2D, a heating arrangement **208** is arranged inside an enclosure **204.** There is an optical coupling, by optical means **230,** between the optical assembly **212** of the heating arrangement **208** and the laser heating source **210** to provide an optical path for laser light from the laser heating source **210** to the optical assembly **212.** In the example illustrated in FIG. 2D, an optical assembly **212** is disposed directly in front of a fixture **214** in the enclosure. The fixture has a semiconductor structure **202** mounted therein. The fixture **214** is configured in a similar manner as in FIG. 2B, to expose a first surface **202A** of the semiconductor structure **202** to the modified heat beam for heating the surface **202A.** The surface **202A** of the semiconductor structure **202** is at a distance from the optical assembly **212** such that the modified heat beam, during heating, completely and accurately envelops the entire first surface **202A** of the semiconductor structure **202** to enable effective heating thereof without heating the surrounding fixture **214.**

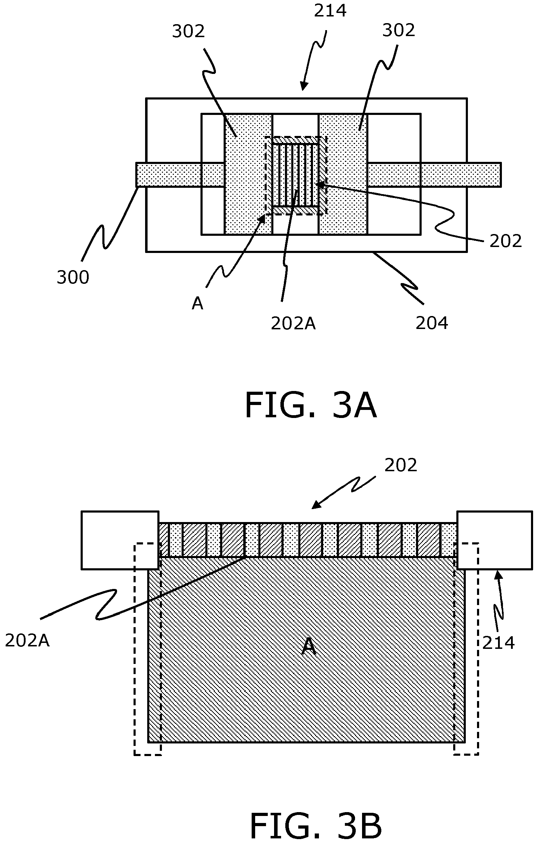

Referring to FIG. 3A, illustrated is a schematic diagram of an exemplary stacking fixture **214,** in accordance with one or more embodiments of the present disclosure. FIG. 3A is a front view of the fixture **214** and its purpose is only to illustrate how the modified heat beam covers the surface area of the semiconductor structure during heating. As shown, the stacking fixture **214** is configured for holding or stacking a plurality of cleaved semiconductor structures **202** therein. The stacking fixture **214** may comprise either screws or springs **300** configured to push the clamps **302** against each other, adding a suitable pressure to keep the plurality of semiconductor structures **202** "sandwiched" between the clamps **302.** Optionally, there can be a separate platform **204** arranged in the fixture **214** for mounting it, as illustrated in FIG. 3A. During heating, the surface of the semiconductor structure is exposed to the modified heat beam by the fixture. The area of the rectangle **A** limited by dashed lines on top of the first surface **202A** of the semiconductor structure, is to illustrate a modified heat beam **A** adjusted to cover at least the whole semiconductor surface **202.** As seen in FIG. 3A, the modified heat beam extends width wise across the whole surface **202A,** between the clamps **302** of the fixture, and vertically (perpendicular to the width direction) across the whole surface **202A** between the top edge and lower edge of the semiconductor structure.

Referring to FIG. 3B, illustrated is a detailed view of the exemplary fixture **214** holding the plurality of cleaved semiconductor structures **202.** FIG. 3B is a top view of the fixture **214** and its purpose is only to illustrate how the modified heat beam covers the surface area of the semiconductor structure during heating. The area of the rectangle **A,** indicated by diagonal lines below the semiconductor structure **202,** in FIG. 3B, is to illustrate a modified heat beam **A** adjusted to cover the whole semiconductor surface **202** exposed to the modified heat beam by the fixture. In FIG. 3B, there is only illustrated a first surface **202A** of the semiconductor structure **202.** As shown both in FIG. 3A and FIG. 3B, the modified heat beam covers the entire surface area of the semiconductor structure **202** that is left exposed by the fixture **214** of the semiconductor structure. Only a small portion of the modified heat beam is directed to the edge of the fixture **214** during heating, in this example. The largest portion of the modified heat beam is directed to the exposed surface **202A** of the semiconductor structure **202.** In FIG. 3B, the modified heat beam **A** extends across the surface **202A,** between the opposite clamps of the fixture, and covers the whole surface **202A,** from the side from which the modified heat beam is directed toward the surface, or the surface facet. The modified heat beam **A** only slightly overlaps the fixture **214** at its peripheral areas, i.e., the areas of the fixture (clamps) that receive the semiconductor structure. The peripheral areas where the fixture **214** is exposed to the modified heat beam are indicated by dashed line rectangles in FIG. 3B.

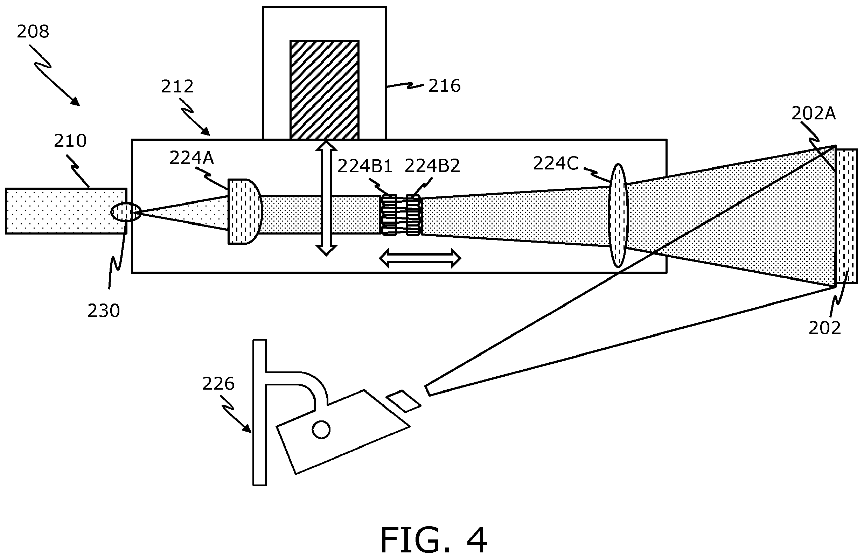

Referring to FIG. 4, illustrated is a representative diagram depicting heating operation of a surface **202A** of the semiconductor structure **202** via the method **100** or system **200,** in accordance with one or more embodiments of the present disclosure. It will be appreciated that FIG. 4 may be read in conjunction with FIGs. 1, 2A, 2B, 2C, 3A and 3B. As shown, the laser heating source **210** is coupled to the optical assembly **212** by an optical means **230,** e.g., one or more optical fibres. The laser heating source **210** is configured to emit heat beam having a first beam profile towards the optical assembly **212** for modification into the modified heat beam having a second beam profile. The optical assembly **212** comprises a first optical device **224A** configured for collimating the heat beam from the laser heating source **210** into a collimated heat beam. For example, the first optical device **224A** is a collimating lens. The system **200** further comprises a laser power meter **216** configured to measure power of the heat beam (i.e., the collimated heat beam). Herein, optionally, the determined power is assessed via a processor **228** (not shown) and if the determined power is assessed as above, or below, a predefined power threshold, the processor **228** may be configured to alter the second beam profile by varying the current supplied to the laser heating source in order to obtain the desired power for the heat beam. The optical assembly **212** further comprises second optical devices **224B1** and **224B2** configured for transforming the collimated heat beam (i.e., the heat beam with the first beam profile) into a rectangular modified heat beam with a top-hat intensity distribution (i.e., the modified heat beam having the second beam profile). The second optical devices **224B1** and **224B2** may be optical lens arrays operable to divide the collimated heat beam into multiple smaller heat beams (or beamlets). The optical assembly **212** further comprises a third optical device **224C** configured to focus or expand the multiple beamlets to form the modified heat beam having the second beam profile i.e., the rectangular flat-top intensity profile, to be directed onto the first surface **202A** of the semiconductor structure **202** for heat treatment thereof. For example, the third optical device **224C** may be a focusing lens or a biconvex lens. Herein, the second optical devices **224B1** and **224B2** along with the third optical device **224C** forms an adjustable beam homogenizer, wherein the size or shape of the modified heat beam may be varied by changing the positions of the second optical devices **224B1** and **224B2,** or the third optical device **224C_**(focusing lens), or both. The system **200** further comprises a thermal sensor **226** configured to determine temperature distribution on the first surface **202A** of the semiconductor structure **202.** Upon determining the temperature distribution, the processor **228** (not shown) is further configured to alter the second beam profile of the modified heat beam based on the temperature distribution determined via the thermal sensor **226.** Such an implementation enables development of a feedback loop, wherein the feedback (i.e., the determined power and temperature distribution) is utilized to alter the second beam profile such as, via changing the current supplied to the laser heating source **210.**

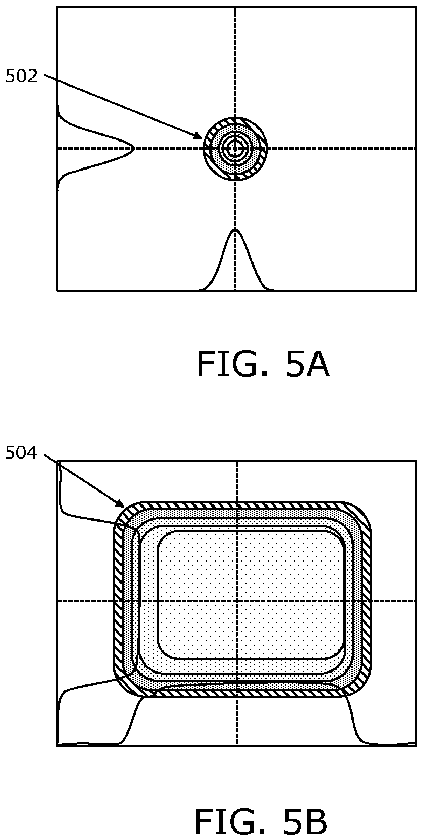

Referring to FIG. 5A and 5B, illustrated are graphical representations of an exemplary first beam profile of the heat beam and the second beam profile of the modified heat beam, respectively, in accordance with one or more embodiments of the present disclosure. As shown, in FIG. 5A, illustrated is the first beam profile **502** having a power intensity Gaussian distribution, or a quasi-Gaussian distribution. The Gaussian beam profiles are symmetric around the center of the heat beam and decreases as the distance from the center of the beam perpendicular to the direction of propagation increases. Thus, the heat beam having the Gaussian beam profile provides a non-uniform temperature distribution and therefore results in uneven heating of the semiconductor structure which potentially results in surface deterioration and a poorer quality semiconductor device. As a result, to overcome the aforementioned drawbacks, the optical assembly **212** of the present disclosure is configured to modify the heat beam having a Gaussian beam profile into the modified heat beam having a second beam profile **504,** wherein the second beam profile **504** comprises a rectangular flat-top beam profile configured to uniformly heat the first surface **202A** of the semiconductor structure accurately and efficiently. After modifying the laser beam shape and intensity via optical devices **224,** the required shape and size of the modified heat beam are obtained with a uniform power distribution.

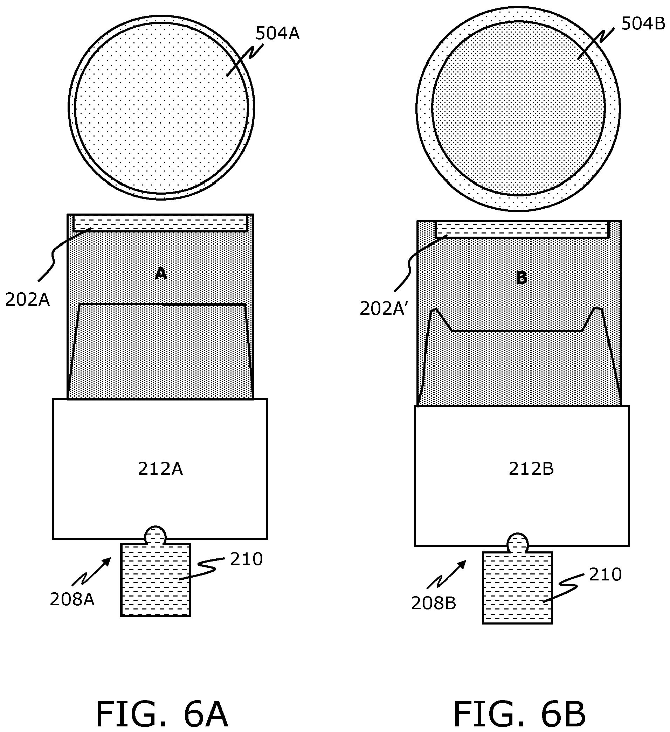

Referring to FIGs. 6A and 6B, illustrated are schematic diagrams of exemplary heating arrangements **208A** and **208B** configured for providing modified heat beam having different beam profiles, in accordance with an embodiment of the present disclosure. A continuous solid curve in the modified heat beam **A,** between the first surface **202A** of the semiconductor structure and the optical assembly **212A,** and respectively, a continuous solid curve in the modified heat beam **B,** between the first surface **202A'** of the semiconductor structure and the optical assembly **212B,** illustrate, by way of example, the different intensity profiles across the cross-section of the modified heat beam to which the first surface of the semiconductor structure is exposed. As shown, in FIG. 6A, illustrated is a first heating arrangement **208A** comprising a laser heating source **210** and a first optical assembly **212A,** operatively coupled with the laser heating source **210,** configured to modify the first beam profile of the heat beam from the laser heating source **210** into the modified heat beam **A** having the second beam profile **504A,** wherein the second beam profile **504A** is a round beam with a top-hat intensity profile. Herein, the heat beam from the laser heating source **210** is adjusted so that it covers at least the whole first surface **202A** of the semiconductor structure during heating. Similarly, as shown, in FIG. 6B, illustrated is a second heating arrangement **208B** comprising a laser heating source **210** and a second optical assembly **212B,** operatively coupled with the laser heating source **210,** configured to modify the first beam profile of the heat beam from the laser heating source **210** into the modified heat beam **B** having the second beam profile **504B,** wherein the second beam profile **504B** is a round beam with a specific intensity profile. Herein, the heat beam from the laser heating source **210** is adjusted so that it covers at least the whole first surface **202A** of the semiconductor structure. Additionally, the beam profile **504A** can be adjusted with specifically designed optical elements of the optical assembly **212A,** so that the intensity is either uniform throughout the whole surface **202A,** or has a certain intensity profile **504A** or **504B** i.e., laser beam intensity could be higher in the edges of the substrate **202** such as, via engineered diffusers **224,** to compensate the higher heat exchange rate on the edges, and to try to have a more uniform temperature distribution through the whole substrate **202** during the treatment processes.

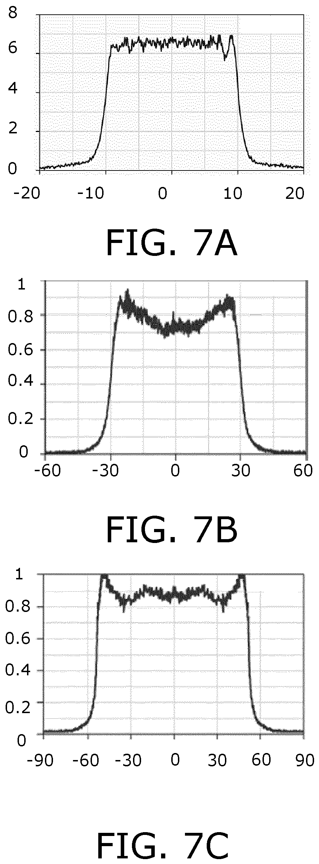

Referring to FIGs. 7A to 7C, collectively, illustrated are graphical representations of different exemplary beam intensity profiles of the modified heat beam, in accordance with an embodiment of the present disclosure. Herein, the x-axis denotes the scatter angle of the heat beam, and the y-axis denotes the relative intensity. As shown, in FIG. 7A, illustrated is a 20-degree square distribution of the modified heat beam. Further, as shown in FIG. 7B, illustrated is a 50-degree square distribution of the modified heat beam. Furthermore, as shown in FIG. 7B, illustrated is a 100-degree line distribution of the modified heat beam. Notably, as shown, the beam profiles may be obtained via modification of the heat beam from the laser heating source **210** modified via at least one optical device **224,** wherein the at least one optical device **224** is an engineered diffuser, or a lightguide, configured to extract higher power from certain areas.

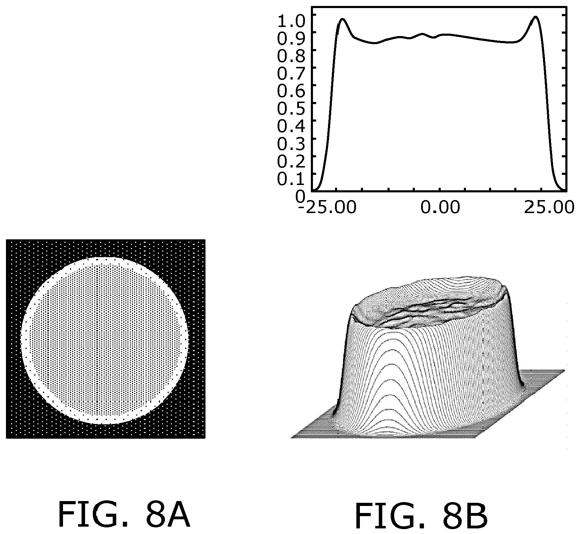

Referring to FIGs. 8A and 8B, illustrated are 2-D and 3-D intensity plots of the modified heat beam along with respective graphical intensity plots, respectively, in accordance with one or more embodiments of the present disclosure. As shown, in FIG. 8B, in the upper curve, the intensities (shown in arbitrary units in y-axis) of the modified heat beam are higher at the edges and relatively uniform around the central region (on either side of 0.00 on the x-axis). The intensity at the edges is kept higher in comparison to the central region to compensate for the higher heat exchange rates at the edges of surface **202A** of the semiconductor structure **202.**

## Claims

1. A method (100) of heating a surface (202A, 202B) of a semiconductor structure (202) to be processed, the method (100) comprising:
- providing an enclosure (204), comprising a fixture (214), to mount the semiconductor structure thereon;
- mounting the semiconductor structure on the fixture (214);
- providing, by a laser heating source (210), a heat beam having a first beam profile (502);
- modifying the first beam profile (502), by an optical assembly (212), to provide a modified heat beam having a second beam profile (504) with a predefined intensity distribution, and a predefined size and shape, such that predefined size and shape correspond to a size and a shape of a first surface (202A) of the semiconductor structure (202) to be processed, to cover substantially the entire surface area of the first surface (202A) of the semiconductor structure (202) by the modified heat beam; and
- directing the modified heat beam having the second beam profile toward the first surface (202A) of the semiconductor structure for heating the first surface to be processed.

2. The method according to claim 1 further comprising:
- providing, by a second laser heating source (220), a heat beam having a third beam profile;
- modifying the third beam profile, by an optical assembly (222), to provide a modified heat beam having a fourth beam profile with a predefined intensity distribution, and a predefined size and a predefined shape, that predefined size and shape correspond to a size and a shape of a second surface (202B) of the semiconductor structure (202) to be processed, to cover substantially the entire surface area of the second surface (202B) of the semiconductor structure (202) by the modified heat beam; and
- directing the modified heat beam having the fourth beam profile toward the second surface (202B) of the semiconductor structure for heating the second surface to be processed.

3. The method (100) according to claim 1, further comprising:
- determining at least a size and a shape of the first surface (202A) of the semiconductor structure (202); and
- modifying the first beam profile (502) of the heat beam from the laser heating source, by the optical assembly (212), to provide the second beam profile based on the determined size and shape of the first surface (202A) of the semiconductor structure.

4. The method (100) according to claim 2, further comprising:
- determining at least a size and a shape of the second surface (202B) of the semiconductor structure (202); and
- modifying the third beam profile of the heat beam from the laser heating source, by the optical assembly (212), to provide the fourth beam profile based on the determined size and shape of the second surface (202B) of the semiconductor structure.

5. The method (100) according to claim 1 or 2, wherein the step of modifying, comprises:
- defining at least one of: an intensity or intensity distribution, a power distribution, a size, a shape, a polarization, a phase, of each heat beam by utilizing at least one optical device (224), to provide the modified heat beam having the second beam profile (504), or the fourth beam profile, respectively.

6. The method according to claim 5, wherein the at least one optical device (224) of the optical assembly (212), or the second optical assembly (222), is selected from at least one of: a collimator lens, a beam shaper, a beam homogenizer, an optical lens, a light guide, and an optical filter.

7. The method (100) according to any of the preceding claims, further comprising at least one of:
- determining power of the heat beam, or the modified heat beam, via a laser power meter (216); and
- determining a temperature distribution of the first surface (202A), or the second surface (202B), of the semiconductor structure via a thermal sensor (226).

8. The method (100) according to claim 7, further comprising:
- altering the second beam profile, or the fourth beam profile, of the modified heat beam based on at least one of: the power determined via the laser power meter, the temperature distribution determined via the thermal sensor.

9. The method (100) according to any of the preceding claims, further comprising:
- directing, by an optical means (230, 231), the heat beam from the at least one laser heating source (210, 220) to the at least one optical assembly (212, 222).

10. A system (200) for heating a surface (202A, 202B) of a semiconductor structure (202) to be processed, the system (200) comprising:
- an enclosure (204);
- a fixture (214) adapted to mount the semiconductor structure (202) thereon;
- a heating arrangement (208) comprising at least:
- a laser heating source (210) configured to provide heat beam having a first beam profile (502); and
- an optical assembly (212), operatively coupled with the laser heating source,
wherein the optical assembly (212) is configured to modify the first beam profile (502) of the heat beam to provide a modified heat beam having a second beam profile (504), and to direct the modified heat beam toward a first surface (202A) of the semiconductor structure for heating the first surface to be processed.

11. The system (200) according to claim 10 further comprising
- a second heating arrangement (218) comprising:
- a second laser heating source (220) configured to provide heat beam having a third beam profile (404), and
- a second optical assembly (222), operatively coupled with the second laser heating source (220),
wherein the second optical assembly (222) is configured to modify the third beam profile of the heat beam to provide a modified heat beam having a fourth beam profile and to direct the modified heat beam toward a second surface (202B) of the semiconductor structure for heating the second surface to be processed.

12. The system (200) according to claim 10 or 11, wherein the optical assembly (212, 222) further comprises at least one optical device (224) configured to define at least one of: a power intensity, a power distribution, a size, a shape, a polarization, a phase, of each heat beam to provide the modified heat beam having the second beam profile (504), or the fourth beam profile (414), respectively.

13. The system (200) according to claim 12, wherein the at least one optical device (224) of the optical assembly (212), or the second optical assembly (222), is selected from at least one of: a collimator lens, a beam shaper, a beam homogenizer, an optical lens, a light guide, and an optical filter.

14. The system (200) according to any of the claims 10-13, wherein the system further comprises:
- a laser power meter (216) configured for determining power of the heat beam or the modified heat beam; and
- a thermal sensor (226) configured for determining a temperature distribution of the first surface (202A), or the second surface (202B), of the semiconductor structure (202).

15. The system (200) according to any of the claims 10-14, wherein the system further comprises an optical means (230, 231) configured to direct the heat beam from the laser heating source (210) to the optical assembly (212, 222),
